Europäisches Patentamt

European Patent Office

Office européen des brevets

(11) Veröffentlichungsnummer: **0 375 893**
**A2**

## EUROPÄISCHE PATENTANMELDUNG

(21) Anmeldenummer: 89120642.7

(51) Int. Cl.⁵: **H03L 7/18, H03L 7/093**

(22) Anmeldetag: 08.11.89

(30) Priorität: 24.12.88 DE 3843835

(43) Veröffentlichungstag der Anmeldung:
04.07.90 Patentblatt 90/27

(84) Benannte Vertragsstaaten:
**AT CH DE FR GB IT LI NL SE**

(71) Anmelder: **ROBERT BOSCH GMBH**
**Postfach 10 60 50**
**D-7000 Stuttgart 10(DE)**

(72) Erfinder: **Hof, Manfred, Dipl.-Ing.**
**Mäckeritzstrasse 5**
**D-1000 Berlin 13(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**D-1000 Berlin 33(DE)**

(54) **Schaltungsanordnung zur Verbesserung der Frequenzgenauigkeit eines in der Funktechnik verwendeten Referenzoszillators.**

(57) Es Wird eine Schaltungsanordnung zur Verbesserung der frequenzgenauigkeit und Reduktion des Schaltungsaufwandes eines in der Funktechnik verwendeten Referenzoszillators, insbesondere für Mobilfunktelefone, vorgeschlagen, bei der die demodulierte, von der Feststation ankommende Datenfrequenz ais Vergleichsfrequenz verwendet wird. Über eine Regelschaltung wird der Referenzoszillator nachgeregelt, wobei die Regelspannung unter Berücksichtigung der Frequenz des Referenzoszillators und der Datenfrequenz gewonnen wird. Die Referenzfrequenz des Referenzoszillators wird derart gewählt, daß sie ein ganzzahliges Vielfaches der Datenfrequenz ist. Die Frequenz des Referenzoszillators wird nach Teilung mit der Datenfrequenz verglichen. Das resultierende Signal aus dem Vergleich wird einem D/A-Wandler zugeführt, dessen Ausgangsspannung als Regelspannung auf den Regeleingang des Referenzoszillators gegeben wird.

## Schaltungsanordnung zur Verbesserung der Frequenzgenauigkeit eines in der Funktechnik verwendeten Referenzoszillators

Die Erfindung betrifft eine Schaltungsanordnung zur Verbesserung der Frequenzgenauigkeit und Reduktion von Schaltungsaufwand eines in der Funktechnik verwendeten Referenzoszillators, insbesondere für Mobilfunktelefone nach dem Oberbegriff des Hauptanspruchs.

Bei Mobilfunktelefonen Netz C wird von der Feststation eine bestimmte Datenrate vorgegeben, die mit 5,28 kHz demoduliert wird. Um die Frequenzgenauigkeit des als Sender- und Empfängeroszillators dienenden Referenzoszillators zu erhöhen, ist es bekannt, die auf $\pm 10^{-8}$ genaue Datenfrequenz von 5,28 kHz für eine Regelung der Frequenz des freischwingenden quarzstabilisierten Referenzoszillators zu verwenden. Dazu wird in einem Mikroprozessor die Frequenz eines freilaufenden Oszillators (6,758 MHz) heruntergeteilt und mit der Datenfrequenz verglichen. Der Ausgang des Mikroprozessors, der das Ergebnis dieses Vergleiches betrifft, und die Frequenz des freilaufenden Oszillators wird auf einen Differenzbildner gegeben, so daß an dessen Ausgang eine genaue Frequenz von 6,584 MHz anliegt. Der Referenzoszillator ist Teil einer PLL-Schaltung, die einen mit dem Oszillator verbundenen Frequenzteiler eine Phasenvergleichsstufe und einen Tiefpaß aufweist, der zwischen Oszillator und Phasenvergleichsstufe geschaltet ist. Die Phasenvergleichsstufe erhält somit einerseits eine Spannung mit der um 1250 heruntergeteilten Frequenz von 12,8 MHz des Oszillators und andererseits eine Spannung mit der um 66 heruntergeteilten Frequenz von 6,7584 MHz, d.h. es wird eine Frequenz von 102,4 kHz beglichen. Die Ausgangsspannung der Phasenvergleichsstufe wird über den Tiefpaß dem Referenzoszillator als Steuerspannung bzw. Regelspannung zugeführt. Eine derartige Referenzfrequenzregelung nach dem Stand der Technik weist einen relativ aufwendigen Regelkreis auf, wobei die Bauteilezahl verhältnismäßig groß ist und aufgrund der erhöhten Bauteilezahl ist ebenfalls der Stromverbrauch relativ hoch.

Der vorliegenden Erfindung liegt somit die Aufgabe zugrunde, eine Schaltungsanordnung zur Verbesserung der Frequenzgenauigkeit eines Referenzoszillators gemäß dem Oberbegriff zu schaffen, die gegenüber dem Stand der Technik eine verringerte Bauteileanzahl aufweist und einen geringeren Stromverbrauch hat, wobei eine hohe Frequenzgenauigkeit gewährleistet sein soll.

Diese Aufgabe wird erfindungsgemäß durch die kennzeichnenden Merkmale des Hauptanspruchs in Verbindung mit den Merkmalen des Oberbegriffs gelöst.

Dadurch, daß die Frequenz des Referenzoszillators, die ein ganzes Vielfaches der Datenfrequenz beträgt und die heruntergeteilt wird, mit der Datenfrequenz verglichen wird und das resultierende Vergleichssignal auf einen D/A-Wandler gegeben wird, dessen Ausgangssignal als Steuersignal für den Referenzoszillator verwendet wird, wird eine Frequenzregelung mit großer Genauigkeit und mit nur wenigen Bauelementen zur Verfügung gestellt. Es wird eine vollständige Regelschleife mit Quarzgenerator eingespart.

Durch die in den Unteransprüchen angegebenen Maßnahmen sind vorteilhafte Weiterbildungen und Verbesserungen möglich.

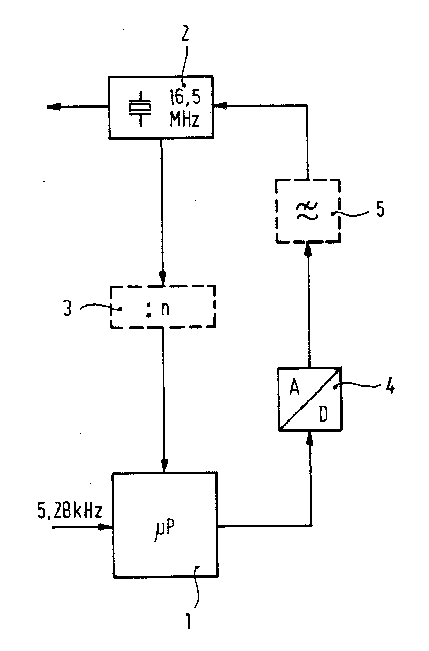

Ein Ausführungsbeispiel der Erfindung ist in der Zeichnung dargestellt und wird in der nachfolgenden Beschreibung näher erläutert.

Die einzige Figur zeigt eine schaltungsgemäße Ausgestaltung der Schaltungsanordnung nach der Erfindung.

Bei der Mobilfunktelefonanlage Netz C, für die die Schaltungsanordnung gemäß der Figur angewandt wird, wird von der Feststation ein Datentakt gesendet, der in der Mobilstation mit 5,2 kHz demoduliert wird, wobei diese Frequenz eine Genauigkeit von $10^{-8}$ aufweist. Die Frequenz des Datentaktes wird in einer Regelschleife als Vergleichsfrequenz für die Regelung der Referenzfrequenz des Referenzoszillators der Mobilstation verwendet. Dazu wird der empfangene Datentakt einem Mikroprozessor 1 zugeführt, der mit einem freischwingenden, temperaturkompensierten, quarzstabilisierten Oszillator 2 verbunden ist. Die Frequenz des Referenzoszillators ist derart gewählt, daß sie ein ganzzahliges Vielfaches der Datenfrequenz ist und beträgt im Ausführungsbeispiel vorzugsweise 16,5 MHz. Zwischen Referenzoszillator 2 und Mikroprozessor 1 kann ein Vorteiler 3 vorgesehen sein, der aber nur für bestimmte, langsame Mikroprozessortypen notwendig ist. Der Mikroprozessor teilt die Frequenz des Referenzoszillators 2 durch 3125 (ohne Vorteiler) und vergleicht diese geteilte Frequenz mit der Frequenz des Datentaktes. Die das Ergebnis dieses Vergleichs darstellende Spannung wird auf einen mit dem Ausgang des Mikroprozessors 1 verbundenen D/A-Wandler 4 gegeben, der mit dem Steuereingang des Referenzoszillators 2 verbunden ist. In dem D/A-Wandler wird das von dem Mikroprozessor gelieferte digitale Signal, das eine Abweichung von der Referenzfrequenz des Referenzoszillators darstellt, in ein analoges Signal umgewandelt und als Regelspannung bzw. Steuerspannung dem Referenzoszillator 2 zugeführt. Gegebenenfalls kann zwischen D/A-Wandler 4 und Referenzoszillator 2 ein Tiefpaß 5 geschaltet Werden, der Störungen ausblendet. Der D/A-Wandler 4 kann als 8-Bit-Wandler ausgebildet sein, wobei die Genauigkeit noch verbessert werden kann, wenn beispielsweise ein 12-Bit-Wandler, d.h. ein Wandler mit einer höheren Bit-Zahl verwendet wird.

In dem beschriebenen Ausführungsbeispiel wird ein Mikroprozessor 1 als Teiler und Vergleicher verwendet. Selbstverständlich können anstelle des Mikroprozessors 1 Zähler und Vergleichsstufen vorgesehen sein, die die gleiche Funktion ausführen.

Als Frequenz für den Referenzoszillator 2 kann auch eine niedrigere oder eine höhere Frequenz verwendet werden, wenn sie durch 5280 teilbar ist. Der Mikroprozessor 1 und der Digital/Analog-Wandler 4 können auch für weitere Funktionen in der Mobilstation dienen, wobei dann ein weiterer Regelkreis gebildet wird, beispielsweise kann eine Gleichtaktkompensation durchgeführt werden. Dazu werden zwischen D/A-Wandler 4 und Referenzoszillator Umschalter, beispielsweise ein Multiplexer, und eine Sample und Hold Schaltung geschaltet, wobei die Sample und Hold Schaltung mit dem Regeleingang des Referenzoszillators verbunden ist und einen weiteren Ausgang für die Gleichtaktregelung aufweist.

## Ansprüche

1. Schaltungsanordnung zur Verbesserung der Freqenzgenauigkeit eines in der Funktechnik verwendeten Referenzoszillators, insbesondere für Mobilfunktelefone, bei der eine demodulierte von der Feststation ankommende Datenfrequenz als Vergleichsfrequenz dient und über eine Regelschleife der Referenzoszillator nachgeregelt wird, wobei die Regelspannung unter Berücksichtigung der Frequenz des Referenzoszillators und der Datenfrequenz gewonnen wird,
**dadurch gekennzeichnet,**
daß die Frequenz des Referenzoszillators (2) derart gewählt wird, daß sie ein ganzzahliges Vielfaches der Datenfrequenz ist, daß die Frequenz des Referenzoszillators (2) nach Teilung mit der Datenfrequenz verglichen wird und daß das resultierende Signal des Vergleichs einem D/A-Wandler (4) zugeführt wird, dessen Ausgang mit dem Regeleingang des Referenzoszillators verbunden ist und die Regelspannung liefert.

2. Schaltungsanordnung nach Anspruch 1, dadurch gekennzeichnet, daß zwischen D/A-Wandler (4) und Steuereingang des Referenzoszillators (2) ein Tiefpaß (5) geschaltet ist.

3. Schaltungsanordnung nach Anspruch 1 oder 2, dadurch gekennzeichnet, daß die Frequenz des Referenzoszillators (2) 16,5 MHz und die Datenfrequenz 5,28 kHz betragen.

4. Schaltungsanordnung nach einem der Ansprüche 1 bis 3, dadurch gekennzeichnet daß der D/A-Wandler (4) mindestens als 6-Bit-Wandler ausgebildet ist.

EP 0 375 893 A2